# EUROPÄISCHE PATENTSCHRIFT

(11) **EP 1 160 580 B1**
(45) Veröffentlichungstag und Bekanntmachung des Hinweises auf die Patenterteilung: **15.09.2004**
(21) Anmeldenummer: 00110543.6
(22) Anmeldetag: 17.05.2000
(51) Int. Cl.: G01R 31/36

(54) **Schaltungsanordnung zur Detektion einer Funktionsstörung**
Circuit for detecting a malfunction
Circuit pour détecter une fonction fausse

(43) Veröffentlichungstag der Anmeldung: 05.12.2001
(73) Patentinhaber: Infineon Technologies AG, 81669 München (DE)
(72) Erfinder: Tscheternigg, Siegfried, 86946 Vilgertshofen (DE); Allinger, Robert, 82008 Unterhaching (DE)
(74) Vertreter: Epping, Hermann, Fischer

(56) Entgegenhaltungen:
- EP-A- 0 550 389
- US-A- 4 495 471

## Beschreibung

Die Erfindung betrifft eine Schaltungsanordnung gemäß Patentanspruch 1.
In der Druckschrift EP-A-0,550,389 wird eine Anordnung zur Überwachung einer Versorgungsspannung einer Batterie beschrieben. Diese enthält einen ersten und einen zweiten Differenzverstärker, wobei deren Ausgänge mit einer optischen Anzeigevorrichtung verbunden sind, wobei jeweils ein Eingang mit jeweils einem Referenzpotentialanschluß verbunden ist und wobei jeweils der andere Eingang mit der zu überwachenden Versorgungsspannung gekoppelt ist. Ein Unter- oder Überschreiten eines durch den jeweiligen Referenzpotentialanschluß vorgegebenen Spannungslimits wird optisch zur Anzeige gebracht.

Bei niederfrequenten Spannungsschwankungen der Versorgungsspannung bleibt die Funktionsfähigkeit einer integrierten Schaltung in der Regel gewährleistet. Jedoch kann es bei hochfrequenten Störimpulsen zu einem undefinierten Zustand der integrierten Schaltung kommen. Beispielsweise kann die Synchronisation verschiedener Signale der integrierten Schaltung gestört sein. Das Auslesen eines Speicherinhaltes könnte fehlerhaft erfolgen. Ebenso könnten logische Schaltungsanordnungen in negativer Weise beeinflußt werden.

Diese an sich unerwünschten Effekte kann man sich jedoch zu Nutze machen, um den strukturellen Aufbau und die Funktionsweise einer integrierten Schaltung zu ergründen.

Um derartige betrügerische Absichten zu behindern, werden Spannungsschwankungen innerhalb eines spezifizierten Versorgungsspannungsbereiches durch Filterschaltungen ausgeblendet. Hierbei unterbricht die integrierte Schaltung ihren Funktionsablauf in der Regel jedoch nicht.

Die Aufgabe der vorliegenden Erfindung besteht darin, eine Schaltungsanordnung zur Überwachung einer Versorgungspannung bereitzustellen, die hochfrequente Anteile auf der Versorgungsspannung detektiert und eine Reaktion einleitet.

Diese Aufgabe wird mit den Merkmalen des Patentanspruches 1 gelöst.

Die Erfindung macht sich den Umstand zu Nutze, daß in der Regel in jeder integrierten Schaltung eine Schaltungsanordnung vorhanden ist, die Spannungsschwankungen der Versorgungsspannung überwacht. Integrierte Schaltungen können innerhalb eines vorgegebenen Versorgungsspannungsbereich betrieben werden. Übersteigt die Versorgungsspannung eine obere Spannungsschwelle beziehungsweise unterschreitet die Versorgungsspannung eine untere Spannungsschwelle, so wird ein sogenannter "Power On Reset" ausgelöst. Dies bedeutet, die integrierte Schaltung wird nach dem Auslösen eines "Power On Resets" in einen definierten Betriebszustand verbracht. So wird diese Funktionalität beispielsweise dazu genutzt, um die integrierte Schaltung beim Einschalten aufgrund einer von Null stetig ansteigenden Versorgungsspannung beim Erreichen der unteren spezifizierten Spannungsschwelle einen Power On Reset auszulösen, der die integrierte Schaltung sodann in einen definierten Betriebszustand schaltet. Zur Einstellung der unteren und der oberen Spannungsschwelle, welche jeweils den Power On Reset auslöst, sind beispielsweise zwei Spannungsteiler vorgesehen. Der Spannungsteiler, der die obere Schaltschwelle definiert, wird auf den einen Eingang des ersten Operationsverstärkers geführt, während der Spannungsteiler, der die untere Schaltschwelle definiert, auf den einen Eingang des zweiten Operationsverstärkers geführt wird. Die jeweils anderen Eingänge des ersten und des zweiten Operationsverstärkers sind mit einem Referenzpotentialanschluß verbunden, an dem eine fest eingestellte Referenzspannung anliegt. Die Ausgänge des ersten und des zweiten Operationsverstärkers werden einem Gatter zugeführt, welches die von dem ersten und dem zweiten Operationsverstärker gelieferte Signal auswertet und an einem Ausgang zur Verfügung stellt. Der Ausgang dieser Schaltungsanordnung ist mit einem anderen Schaltungsbereich der integrierten Schaltung verbunden, der dann den Power On Reset auslösen kann.

Da diese Schaltungsanordnung zur Detektion einer Spannungsschwankung jedoch nicht geeignet ist, hochfrequente Spannungsschwankungen zu erfassen, die sich innerhalb der Resetschwellen bewegen, sieht die Erfindung vor, den jeweils anderen Eingang des ersten und zweiten Differenzverstärkers mit einem Überwachungsmittel zu verbinden, das bei einer Änderung der Versorgungsspannung an einem Versorgungspotentialanschluß der Schaltungsanordnung anspricht.

Vorteilhafte Ausgestaltungen ergeben sich aus den untergeordneten Ansprüchen.

Vorzugsweise ist jedem Differenzverstärker ein Überwachungsmittel zugeordnet.

Das Überwachungsmittel kann beispielsweise als Differenzierer ausgeführt sein. Es kann jedoch auch ein Ladungsspeicher sein, der mit dem Versorgungspotentialanschluß verbunden ist. Je nach Dimensionierung der Überwachungsmittel kann eingestellt werden, bei welchen Änderungsgeschwindigkeiten der Versorgungsspannung der jeweilige Operationsverstärker ansprechen soll. Vorzugsweise werden die Bauelemente derart dimensioniert, daß lediglich hochfrequente Spannungsänderungen der Versorgungsspannung detektiert werden. Auf diese Weise kann eine Störung, bei dem die Versorgungsspannung mit dem Ziel, Funktionsstörungen im Ablauf der integrierten Schaltung zu erreichen, unterbunden werden. Da niederfrequente Spannungsänderungen den Ablauf der integrierten Schaltung in der Regel nicht beeinträchtigen, muß das Überwachungsmittel nicht ansprechen, das heißt, die Referenzspannung, die an den einen Eingängen des ersten und des zweiten Operationsverstärkers anliegt, übersteigen.

In einer bevorzugten Ausgestaltung ist ein Spannungsteiler zwischen dem Versorgungspotentialanschluß und einem Bezugspotentialanschluß vorgesehen, dessen Mittelabgriff mit dem jeweiligen Überwachungsmittel und dem jeweiligen Differenzverstärker verbunden ist. Der Spannungsteiler dient, wie eingangs erwähnt, dazu, die obere und die untere Spannungsschwelle einzustellen. Es ist folglich sowohl für den ersten als auch für den zweiten Differenzverstärker jeweils ein eigener Spannungsteiler vorgesehen.

Anhand der nachfolgenden Ausführungsbeispiele werden weitere Vorteile und Ausgestaltungsvarianten der Erfindung erläutert. Es zeigen:
- Figur 1: ein erstes Ausführungsbeispiel der erfindungsgemäßen Schaltungsanordnung zur Detektion einer Funktions störung, wobei als Überwachungsmittel ein Ladungs speicher vorgesehen ist,
- Figur 2: ein zweites Ausführungsbeispiel der erfindungsgemäßen Schaltungsanordnung zur Detektion einer Funktionsstörung, wobei als Überwachungsmittel ein Differenzierer vorgesehen ist und
- Figur 3: eine Ausführungsform eines Differenzierers, der in der Schaltungsanordnung nach Figur 2 zum Einsatz kommt.

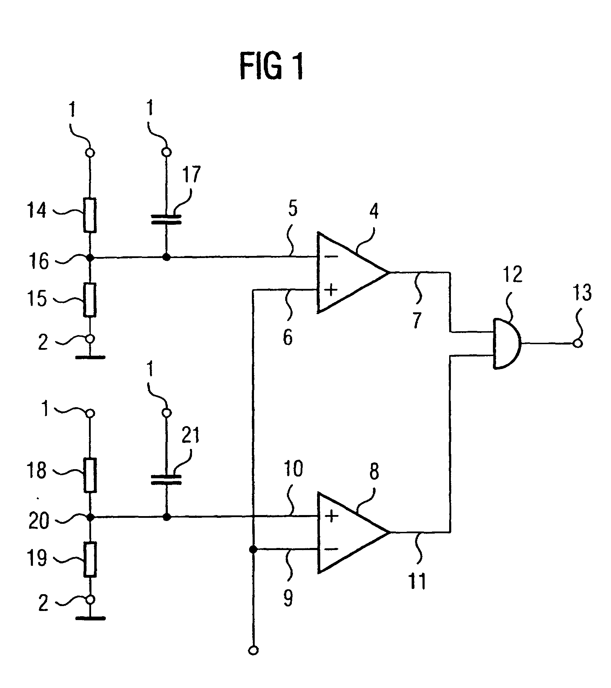

Die Figur 1 zeigt ein bevorzugtes Ausführungsbeispiel der Schaltungsanordnung zur Detektion einer Funktionsstörung. Diese Schaltungsanordnung ermöglicht es gleichzeitig, die aus dem Stand der Technik bekannte Funktionalität, eine obere und eine untere Spannungsschwelle für die Versorgungsspannung zu überwachen und andererseits hochfrequente Störimpulse, welche innerhalb dieses spezifizierten Versorgungsspannungsbereiches auftreten, zu erfassen und am Ausgang der Schaltungsanordnung ein Signal abzugeben, welches es ermöglicht, die integrierte Schaltung in einen sicheren Zustand zu verbringen.

Die Schaltungsanordnung weist hierzu einen ersten und einen zweiten Differenzverstärker 4, 8 auf. Die Ausgänge 7, 11 des ersten und des zweiten Differenzverstärkers 4, 8 sind mit den Eingängen eines Gatters 12 verbunden. Der Ausgang 13 des Gatters 12 ist mit einer nicht gezeigten weiteren Schaltungsanordnung verbunden, welche den Power On Reset auslösen kann. Der nicht invertierende Eingang 6 des ersten Differenzverstärkers 4 sowie der invertierende Eingang 9 des zweiten Differenzverstärkers 8 sind mit einem Referenzpotentialanschluß 3 verbunden, an dem eine fest eingestellte Referenzspannung anliegt. Der invertierende Eingang 5 des ersten Differenzverstärkers 4 ist mit dem Mittelabgriff 16 eines Spannungsteilers, bestehend aus Widerständen 14, 15, verbunden. Der Spannungsteiler ist zwischen einem Versorgungspotentialanschluß 1 und einem Bezugspotentialanschluß 2 gelegen. Ein weiterer Spannungsteiler, bestehend aus den Widerständen 18, 19, ist ebenfalls zwischen dem Versorgungspotentialanschluß 1 und dem Bezugspotentialanschluß 2 gelegen. Der Mittelabgriff 20 ist mit dem nicht invertierenden Eingang 10 des zweiten Differenzverstärkers 8 verbunden.

Die Widerstände 14, 15 des ersten Spannungsteilers sind derart eingestellt, daß sich am Mittelabgriff 16 eine Spannung einstellt, die etwas kleiner als die Referenzspannung am Referenzpotentialanschluß 3 ist. Die Widerstände 18, 19 des zweiten Spannungsteilers sind hingegen derart eingestellt, daß sich am Mittelabgriff 20 eine Spannung einstellt, die etwas größer als die Referenzspannung am Referenzpotentialanschluß 3 ist. Steigt die am Versorgungspotentialanschluß 1 anliegende Spannung nach oben, so wandert auch die an dem Mittelabgriff 16 des ersten Spannungsteilers anliegende Spannung nach oben. Übersteigt die an dem Mittelabgriff 16 anliegende Spannung die am nicht invertierenden Eingang 6 des ersten Differenzverstärkers 4 anliegende Referenzspannung, so gibt der Differenzverstärker 4 an seinem Ausgang 7 ein Signal ab. Das ODER-Gatter 12 gibt dieses Signal an den Ausgang 13 weiter, wodurch ein Power On Reset ausgelöst werden kann. Andererseits wird beim Absenken der Spannung an dem Versorgungspotentialanschluß 1 am Mittelabgriff 20 eine sinkende Spannung erzeugt, wodurch der zweite Differenzverstärker 8 kippt und am Ausgang 13 der Schaltungsanordnung ebenfalls ein Signal zum Power On Reset erzeugt wird.

Erfindungsgemäß ist ein Überwachungsmittel vorgesehen, welches vorzugsweise bei einer hochfrequenten Änderung der Versorgungsspannung den jeweiligen Differenzverstärker ebenfalls zum Kippen bringt. In dem Ausführungsbeispiel gemäß der Figur 1 ist deshalb zwischen dem Mittelabgriff 16 und dem Versorgungspotentialanschluß 1 ein Ladungsspeicher 17 vorgesehen. Gleichfalls ist zwischen dem Mittelabgriff 20 des zweiten Spannungsteilers und dem Versorgungspotentialanschluß 1 ein Ladungsspeicher 21 vorgesehen. Die Ladungsspeicher 17, 21 wirken bei einer hohen Frequenz, das heißt einem steilen Anstieg der Spannung, wie eine Brücke und heben die Spannung an dem invertierenden Eingang 5 beziehungsweise dem nicht invertierenden Eingang 10 des ersten beziehungsweise zweiten Differenzverstärkers 4,8 über die Referenzspannung an dem anderen Eingang an und erzeugen auf diese Weise ein Power On Reset Signal. Die integrierte Schaltung kann deshalb bei einem Angriff, welcher darauf abzielt, Funktionsstörungen im Signalablauf herbeizuführen, diese in einen sicheren Betriebszustand verbringen. Ein sicherer Betriebszustand kann beispielsweise das Anhalten der integrierten Schaltung sein. Ein Auslesen der Speicherinhalte eines Speicherchips wäre sodann nicht mehr möglich.

Die erfindungsgemäße Schaltungsanordnung zur Detektion einer Funktionsstörung zeichnet sich dadurch aus, daß gegenüber einer im Stande der Technik bereits vorhandenen Schaltungsanordnung lediglich wenige zusätzliche Bauelemente notwendig sind. Durch das Vorsehen eines einfachen Ladungsspeichers kann eine Schaltungsanordnung, welche zur Überwachung von vorgegebenen Spannungs-Schaltschwellen dient, dazu verwendet werden, unbeabsichtigte Funktionsstörungen abzuwehren.

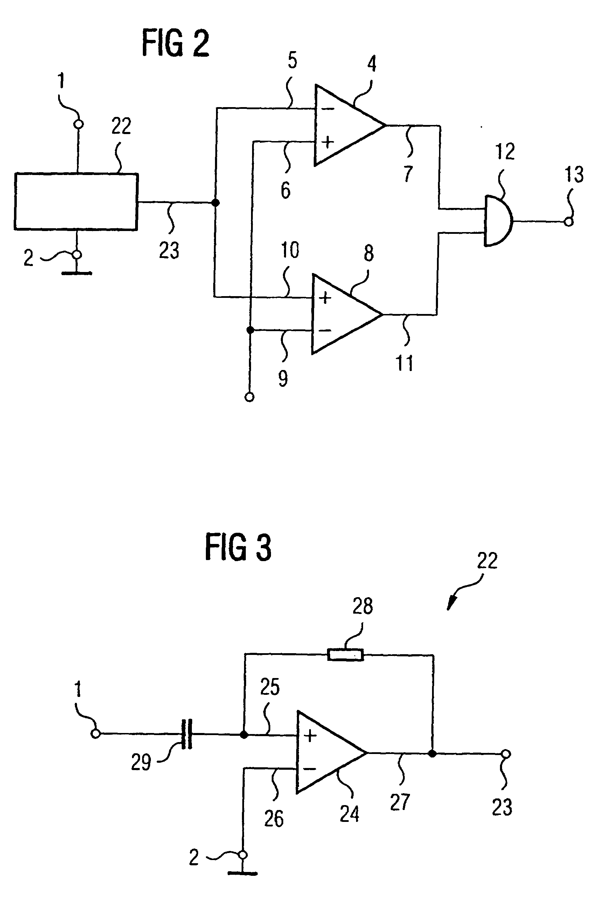

Ein alternatives Ausführungsbeispiel ist in der Figur 2 gezeigt. Die dort gezeigte Schaltungsanordnung dient lediglich dazu, eine Funktionsstörung zu detektieren. Die Überwachung einer oberen und unteren Spannungsschwelle ist bei diesem Ausführungsbeispiel nicht vorgesehen. Anstatt der Beschaltung des invertierenden Einganges 5 des ersten Differenzverstärkers 4 beziehungsweise des nicht invertierenden Einganges 10 des zweiten Differenzverstärkers 8 mit jeweils einem Spannungsteiler sind die beiden genannten Eingänge der Differenzverstärker 4, 8 miteinander verbunden. Der Verbindungspunkt ist mit dem Ausgang 23 eines Differenzierers 22 verbunden, der sich zwischen dem Versorgungspotentialanschluß 1 und dem Bezugspotentialanschluß 2 befindet. Mittels des Differenzierers kann auf einfache Weise der Spannungsanstieg detektiert werden. Der Spannungsanstieg ist ein Maß für die Frequenz der Spannungsänderung. Der Differenzierer kann prinzipiell auf jede beliebige Art und Weise ausgebildet sein. Positive Spannungsanstiege werden dann in der oben beschriebenen Weise von dem ersten Differenzverstärker 4 detektiert, während Spannungsanstiege in negativer Richtung durch den zweiten Differenzverstärker 8 detektiert werden.

Die Figur 3 zeigt ein Ausführungsbeispiel eines Differenzierers, der aus dem Stand der Technik bekannt ist. Der Differenzierer weist einen Differenzverstärker 24 auf, dessen nicht invertierender Eingang mit dem Bezugspotentialanschluß 2 verbunden ist. Der invertierende Eingang 25 ist über einen Ladungsspeicher 29 mit dem Versorgungspotentialanschluß 1 verbunden. Weiterhin ist der invertierende Eingang 25 über einen Widerstand 28 mit dem Ausgang 27 des Differenzverstärkers 24 verbunden. Der Ausgang des Differenzverstärkers 24 stellt gleichsam den Ausgang 23 des Differenzierers dar.

## Patentansprüche

1. Schaltungsanordnung zur Überwachung einer Versorgungsspannung mit einem ersten und einem zweiten Differenzverstärker (4; 8), wobei jeweils ein Eingang (6; 9) mit einem Referenzpotentialanschluß (3) verbunden ist und wobei jeweils der andere Eingang (5; 10) mit der Versorgungsspannung gekoppelt ist,
**dadurch gekennzeichnet, daß** die Ausgänge (7; 11) der Differenzverstärker mit den Eingängen eines Gatters (12) verbunden sind, und daß
der jeweils andere Eingang (5; 10) des ersten und zweiten Differenzverstärkers (4; 8) mit einem Überwachungsmittel (17; 21; 22) verbunden ist, das nur bei einer hochfrequenten Änderung der Versorgungsspannung an einem Versorgungspotentialänschluß (1) der Schaltungsanordnung anspricht.

2. Schaltungsanordnung nach Anspruch 1,
**dadurch gekennzeichnet, daß**
jedem Differenzverstärker (4; 8) ein Überwachungsmittel (17; 21) zugeordnet ist.

3. Schaltungsanordnung nach einem der Ansprüche 1 und 2,
**dadurch gekennzeichnet, daß**
das Überwachungsmittel (17; 21; 22) ein Differenzierer ist.

4. Schaltungsanordnung nach einem der Ansprüche 1 und 2,
**dadurch gekennzeichnet, daß**
das Überwachungsmittel (17; 21; 22) ein Ladungsspeicher ist, der mit dem Versorgungspotentialanschluß (1) verbunden ist.

5. Schaltungsanordnung nach einem der Ansprüche 2 bis 4,
**dadurch gekennzeichnet, daß**
ein Spannungsteiler (14, 15; 18, 19) zwischen dem Versorgungspotentialanschluß (1) und einem Bezugspotentialanschluß (2) vorgesehen ist, dessen Mittelabgriff (16; 20) mit dem jeweiligen Überwachungsmittel (17; 21; 22) und dem jeweiligen Differenzverstärker (4; 8) verbunden ist.

## Claims

1. Circuit arrangement for monitoring a supply voltage having a first and a second differential amplifier (4; 8), one input (6; 9) in each case being connected to a reference potential terminal (3) and the other input (5; 10) in each case being coupled to the supply voltage,
**characterized in that** the outputs (7; 11) of the differential amplifiers are connected to the inputs of a gate (12), and **in that**
the respective other input (5; 10) of the first and second differential amplifiers (4; 8) is connected to a monitoring means (17; 21; 22), which responds only in the event of a high-frequency change in the supply voltage at a supply potential terminal (1) of the circuit arrangement.

2. Circuit arrangement according to Claim 1,
**characterized in that**
a monitoring means (17; 21) is assigned to each differential amplifier (4; 8).

3. Circuit arrangement according to one of Claims 1 and 2,
**characterized in that**
the monitoring means (17; 21; 22) is a differentiator.

4. Circuit arrangement according to one of Claims 1 and 2,
**characterized in that**
the monitoring means (17; 21; 22) is a charge store connected to the supply potential terminal (1).

5. Circuit arrangement according to one of Claims 2 to 4,
**characterized in that**
a voltage divider (14, 15; 18, 19) is provided between the supply potential terminal (1) and a reference-earth potential terminal (2), the centre tap (16; 20) of which voltage divider is connected to the respective monitoring means (17; 21; 22) and the respective differential amplifier (4; 8).

## Revendications

1. Circuit de contrôle d'une tension d'alimentation, comprenant un premier et un deuxième amplificateurs (4, 8) différentiels dans lesquels, respectivement, une entrée (6, 9) est reliée à une borne (3) de potentiel de référence et, respectivement, l'autre entrée (5, 10) est couplée à la tension d'alimentation,
**caractérisé en ce que** les sorties (7, 11) des amplificateurs différentiels sont reliées aux entrées d'une porte (12) et **en ce que** l'autre entrée (5, 10) du premier et du deuxième amplificateurs (4, 8) différentiels est reliée à un moyen (17, 21, 22) de contrôle, qui ne réagit que pour une variation en haute fréquence de la tension d'alimentation sur une borne (1 ) de potentiel d'alimentation du circuit.

2. Circuit suivant la revendication 1, **caractérisé en ce qu'**à chaque amplificateur (4, 8) différentiel est associé un moyen (17, 21) de contrôle.

3. Circuit suivant l'une des revendications 1 et 2, **caractérisé en ce que** le moyen (17, 21, 22) de contrôle est un différentiateur.

4. Circuit suivant l'une des revendications 1 et 2, **caractérisé en ce que** le moyen (17, 21, 22) de contrôle est une mémoire à couplage de charge qui est reliée à la borne (1) de potentiel d'alimentation.

5. Circuit suivant l'une des revendications 2 à 4, **caractérisé en ce qu'**il est prévu entre la borne (1) de potentiel d'alimentation et une borne (2) de potentiel de référence un diviseur (14, 15, 18, 19) de tension, dont la prise (16, 20) médiane est reliée au moyen (17, 21, 22) respectif de contrôle et à l'amplificateur (4, 8) différentiel respectif.
